# EUROPEAN PATENT APPLICATION

(11) **EP 3 389 155 A1**
(43) Date of publication of application: **17.10.2018**
(21) Application number: 16872654.5
(22) Date of filing: 23.08.2016
(51) Int. Cl.: H02H 3/087, H02H 7/20, H03K 17/00, H03K 17/08, H03K 17/687

(54) **DRIVING CIRCUIT**

(30) Priority: 10.12.2015 JP 2015241290
(71) Applicant: Kabushiki Kaisha Tokai-Rika-Denki-Seisakusho, Niwa-gun, Aichi 480-0195 (JP)
(72) Inventor: AOKI, Daisuke, Niwa-gun Aichi 480-0195 (JP)
(74) Representative: TBK
(86) International application number: PCT/JP2016/074547
(87) International publication number: WO 2017/098754

(57) **Abstract**

A drive circuit (12) includes plural drive transistors (18A to 18D) that drive plural load elements (16A to 16D), and an operation limiting circuit (20). The operation limiting circuit (20) is configured by a logic circuit combining AND elements (22A to 24D) and OR elements (24A to 24D). When plural control signals are input to the operation limiting circuit (20) due to abnormal input, the plural drive transistors (18A to 18D) for which the control signals were input are switched OFF.

## Description

### Technical Field

The present invention relates to a drive circuit, and more particularly to a drive circuit that includes plural drive transistors that each drive one of plural loads.

### Background Art

Patent Document 1 discloses an overcurrent protection device. This overcurrent protection device includes a driver transistor, an overcurrent limiting circuit, and an overcurrent detection circuit connected between an external input terminal and an external output terminal. The driver transistor drives a load. In the overcurrent limiting circuit, the gate electrode of the driver transistor is controlled so as to limit excess current. The overcurrent detection circuit detects current flowing between the source region and the drain region of the driver transistor and controls the gate electrode of the driver transistor.

In the above overcurrent protection device, if plural driver transistors are respectively provided so as to drive plural loads, an overcurrent limiting circuit and an overcurrent detection circuit is needed for each of the driver transistors. The scale of circuitry in such an overcurrent protection device thus increases in accordance with the increase in the number of loads, and so there is room for improvement.

### Related Documents

### Related Patent Documents

Patent Document 1: Japanese Patent No. 5434170

### SUMMARY OF INVENTION

### Technical Problem

In consideration of the above circumstances, the present invention provides a drive circuit that is capable of protecting against overcurrent and that is capable of driving plural loads with reduced circuit scale.

### Solution to Problem

A drive circuit according to a first aspect of the present invention includes a first drive transistor, a second drive transistor, and an operation limiting circuit. The first drive transistor and the second drive transistor each have one main electrode region connected to a power supply, and each have another main electrode region respectively connected to a first load or a second load. The operation limiting circuit is connected to a first control electrode of the first drive transistor and connected to a second control electrode of the second drive transistor. The operation limiting circuit is configured to switch ON one of the first drive transistor or the second drive transistor when input with a single control signal for switching ON the one of the first drive transistor or the second drive transistor, and the operation limiting circuit is configured to switch OFF both the first drive transistor and the second drive transistor when input with plural control signals for switching ON both the first drive transistor and the second drive transistor.

The drive circuit according to the first aspect includes the first drive transistor, the second drive transistor, and the operation limiting circuit. One main electrode region of the first drive transistor and one main electrode region of the second drive transistor is connected to a power supply. Another main electrode region of the first drive transistor is connected to the first load and another main electrode region of the second drive transistor is connected to a first load the second load. The operation limiting circuit is connected to the first control electrode of the first drive transistor and the second control electrode of the second drive transistor.

The operation limiting circuit is configured to switch ON one of the first drive transistor or the second drive transistor when input with a single control signal to switch ON one of the first drive transistor or the second drive transistor. Further, the operation limiting circuit is configured to switch OFF both the first drive transistor and the second drive transistor when input with plural control signals to switch ON both the first drive transistor and the second drive transistor. Thus, as the first drive transistor and the second drive transistor are not both switched ON simultaneously, no overcurrent due to both being switched ON arises. Moreover, in the operation limiting circuit, circuit configuration for implementing ON-switching with a single control signal and OFF-switching with plural control signals is able to be simply implemented in a small area.

A drive circuit according to a second aspect of the present invention is the drive circuit according to the first aspect, wherein the operation limiting circuit includes a first AND element and a second AND element. The first AND element outputs to the first control electrode of the first drive transistor a control signal indicating a logical conjunction of a control signal for input to the first drive transistor and a control signal for input to the second drive transistor. The second AND element outputs to the second control electrode of the second drive transistor a control signal indicating a logical conjunction of a control signal for input to the second drive transistor and a control signal for input to the first drive transistor.

In the drive circuit according to the second aspect, the operation limiting circuit includes the first AND element and the second AND element. Both the first AND element and the second AND element are able to be simply implemented in a small area.

A drive circuit according to a third aspect of the present invention is the drive circuit according to the second aspect, wherein the operation limiting circuit includes a first OR element or a first NOT element that outputs to the first AND element a control signal indicating a logical disjunction of control signals for input to the second drive transistor, and a second OR element or a second NOT element that outputs to the second AND element a control signal indicating a logical disjunction of control signals for input to the first drive transistor.

In the drive circuit according to the third aspect, the operation limiting circuit includes either the first OR element or the first NOT element and includes either the second OR element or the second NOT element. Each of these logic elements is able to be simply implemented in a small area.

### Advantageous Effects of Invention

The present invention exhibits the excellent advantageous effect of being able to provide a drive circuit that is capable of protecting against overcurrent and that is capable of driving plural loads with reduced circuit scale.

### BRIEF DESCRIPTION OF DRAWINGS

Fig. 1 is a circuit block diagram of a drive circuit, and of a drive system including the drive circuit, according to a first exemplary embodiment of the present invention.
Fig. 2 is a circuit block diagram of a drive circuit, and of a drive system including the drive circuit, according to a second exemplary embodiment of the present invention.

### DESCRIPTION OF EMBODIMENTS

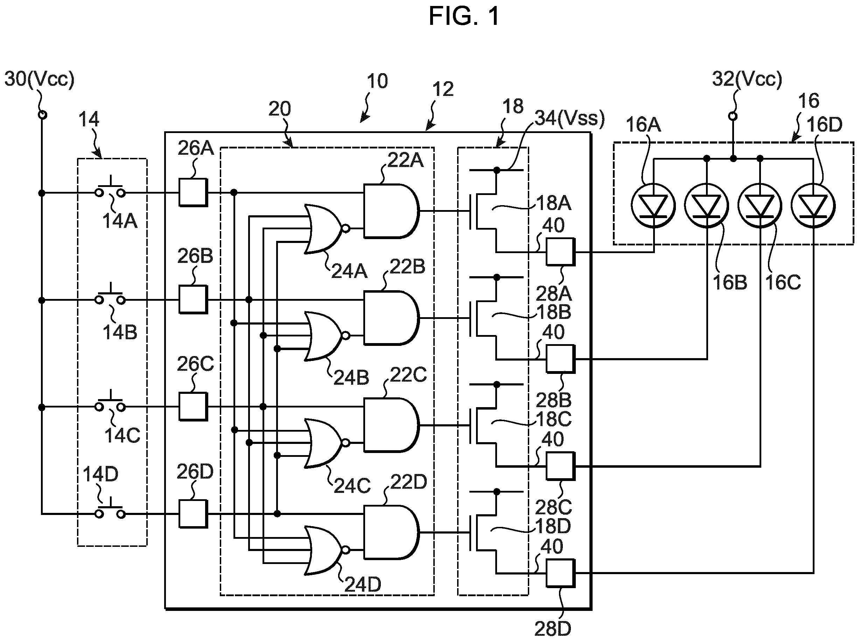

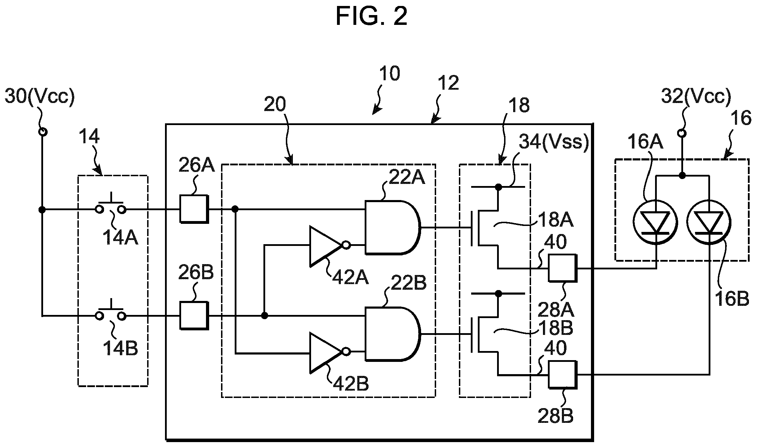

Explanation follows regarding a drive circuit, and a drive system that includes the drive circuit, according to exemplary embodiments of the present invention, with reference to Fig. 1 and Fig. 2.

### First Exemplary Embodiment

### Configuration of Drive Circuit and Drive System

Explanation follows regarding a drive circuit and a drive system according to a first exemplary embodiment of the present invention, with reference to Fig. 1. As illustrated in Fig. 1, a drive system 10 is configured including a drive circuit 12 that is configured as a semiconductor integrated circuit, a switch circuit 14 that is provided on the input side of the drive circuit 12, and a load 16 that is provided on the output side of the drive circuit 12.

In the present exemplary embodiment, the switch circuit 14 includes four switch elements 14A to 14D. One end of each switch element 14A to 14D is connected to a fixed power supply 30. The fixed power supply 30 supplies a power supply voltage Vcc that is, for example, adjusted from an onboard vehicle battery to the voltage required for circuit operation via a non-illustrated power supply circuit. The power supply voltage Vcc is, for example, 5 V, and the power supply voltage Vcc is used for control signals to drive the drive circuit 12. Another end of each switch element 14A to 14D is connected to a respective input terminal 26A to 26D of the drive circuit 12.

The load 16 includes four load elements 16A to 16D that are respectively driven by the switch elements 14A to 14D. In the present exemplary embodiment, a light emitting diode (LED) is employed for each of the load elements 16A to 16D. An anode region at one end side of each load element 16A to 16D is connected to a fixed power supply 32. The fixed power supply 32 supplies the power supply voltage Vcc. A cathode region on another end side of each load element 16A to 16D is connected to a respective output terminal 28A to 28D of the drive circuit 12.

The drive circuit 12 is configured including an output circuit 18 and an operation limiting circuit 20. In more detail, the output circuit 18 is configured including four drive transistors 18A to 18D respectively corresponding to the four load elements 16A to 16D. In the present exemplary embodiment, the drive transistor 18A is employed as a first drive transistor, and the drive transistor 18B is employed as a second drive transistor. In cases in which the drive transistor 18B is employed as a first drive transistor, the drive transistor 18C is employed as a second drive transistor. Similarly, in cases in which the drive transistor 18C is employed as a first drive transistor, the drive transistor 18D is employed as a second drive transistor.

The drive transistors 18A to 18D are all n-channel insulated gate field-effect transistors (IGFETs) having the same structure. Examples of IGFETs include metal-oxide-semiconductor field-effect transistors (MOSFETs) and metal-insulator-semiconductor field-effect transistors (MISFETs). One main electrode region of each of the drive transistors 18A to 18D is employed as a source region, and this source region is connected to a fixed power supply 34. The fixed power supply 34 is set so as to differ from the power supply voltage Vcc, and is set lower than the power supply voltage Vcc, for example to 0 V (ground). Another main electrode region of each of the drive transistors 18A to 18D is a drain region. The drain region of the drive transistor 18A is connected to the another end of the load element 16A via a wiring line 40 and the output terminal 28A. Similarly, the drain region of the drive transistor 18B is connected to the another end of the load element 16B via a wiring line 40 and the output terminal 28B. The drain region of the drive transistor 18C is connected to the another end of the load element 16C via a wiring line 40 and the output terminal 28C. Further, the drain region of the drive transistor 18D is connected to the another end of the load element 16D via a wiring line 40 and the output terminal 28D.

The operation limiting circuit 20 is configured by a logic circuit combining four AND elements 22A to 22D and four OR elements 24A to 24D respectively corresponding to the four drive transistors 18A to 18D. The OR element 24A, serving as a first OR element, is provided at a stage prior to the AND element 22A, serving as a first AND element, and the three inputs of the OR element 24A are connected to the input terminals 26B to 26D but not to the input terminal 26A. The output of the OR element 24A is connected to one of the inputs of the AND element 22A. Another input of the AND element 22A is connected to the input terminal 26A, and the output of the AND element 22A is connected to the gate electrode of the drive transistor 18A, serving as a control electrode therefor.

When the AND element 22A and the OR element 24A are input with a single control signal, for switching ON the drive transistor 18A, the drive transistor 18A is switched ON. When the AND element 22A and the OR element 24A are input with plural control signals, for switching ON the drive transistor 18A and for switching ON at least one of the other drive transistors 18B to 18D, in addition to the drive transistor 18A, any of the drive transistors 18B to 18D for which control signals were input are also switched OFF.

In a similar configuration, the OR element 24B, serving as a second OR element, is provided at a stage prior to the AND element 22B, serving as a second AND element, and the three inputs of the OR element 24B are connected to the input terminals 26A, 26C, and 26D but not to the input terminal 26B. The output of the OR element 24B is connected to one of the inputs of the AND element 22B. Another input of the AND element 22B is connected to the input terminal 26B, and the output of the AND element 22B is connected to the gate electrode of the drive transistor 18B. When the AND element 22B and the OR element 24B are input with a single control signal, for switching ON the drive transistor 18B, the drive transistor 18B is switched ON. When the AND element 22B and the OR element 24B are input with plural control signals, for switching ON the drive transistor 18B and at least one of the other drive transistors 18A, 18C, and 18D, in addition to the drive transistor 18B, any of the drive transistors 18A, 18C, 18D for which control signals were input are also switched OFF.

The OR element 24C is provided at a stage prior to the AND element 22C, and the three inputs of the OR element 24C are connected to the input terminals 26A, 26B, and 26D but not to the input terminal 26C. The output of the OR element 24C is connected to one of the inputs of the AND element 22C. Another input of the AND element 22C is connected to the input terminal 26C, and the output of the AND element 22C is connected to the gate electrode of the drive transistor 18C. Similarly to the drive transistor 18C, in cases in which the AND element 22B is employed as a first AND element and the OR element 24B is employed as a first OR element, the AND element 22C and the OR element 24C are employed as a second AND element and a second OR element, respectively. The AND element 22C and the OR element 24C may also be employed as a first AND element and a first OR element, respectively. When the AND element 22C and the OR element 24C are input with a single control signal, for switching ON the drive transistor 18C, the drive transistor 18C is switched ON. When the AND element 22C and the OR element 24C are input with plural control signals, for switching ON the drive transistor 18C and at least one of the other drive transistors 18A, 18B, and 18D, in addition to the drive transistor 18C, any of the drive transistors 18A, 18B, 18D for which control signals were input are also switched OFF.

The OR element 24D is provided at a stage prior to the AND element 22D, and the three inputs of the OR element 24D are connected to the input terminals 26A to 26C but not to the input terminal 26D. The output of the OR element 24D is connected to one of the inputs of the AND element 22D. Another input of the AND element 22D is connected to the input terminal 26D, and the output of the AND element 22D is connected to the gate electrode of the drive transistor 18D. Similarly to the drive transistor 18D, in cases in which the AND element 22C is employed as a first AND element and the OR element 24C is employed as a first OR element, the AND element 22D and the OR element 24D are employed as a second AND element and a second OR element, respectively. When the AND element 22D and the OR element 24D are input with a single control signal, for switching ON the drive transistor 18D, the drive transistor 18D is switched ON. When the AND element 22D and the OR element 24D are input with plural control signals, for switching ON the drive transistor 18D and at least one of the other drive transistors 18A to 18C, in addition to the drive transistor 18D, any of the drive transistors 18A to 18C for which control signals were input are also switched OFF.

### Operation and Advantageous Effects of the Present Exemplary Embodiment

As illustrated in Fig. 1, the drive circuit 12 according to the present exemplary embodiment includes the four drive transistors 18A to 18D that drive the four load elements 16A to 16D and includes the operation limiting circuit 20. For example, when the switch element 14A is switched ON and the other switch elements 14B to 14D are switched OFF, a high level signal from the fixed power supply 30 passes through the input terminal 26A and is input to the other input of the AND element 22A of the operation limiting circuit 20. Since a low level signal is input to all three inputs of the OR element 24A, the OR element 24A outputs a high level signal to the one input of the AND element 22A. Since high level signals are input to the two inputs of the AND element 22A, a high level signal is output to the gate electrode of the drive transistor 18A and the drive transistor 18A is switched ON. Current therefore flows from the fixed power supply 32 to the fixed power supply 34 via the load element 16A, the output terminal 28A, and the drive transistor 18A. As a LED is employed for the load element 16A, the LED emits light when current flows.

However, when the switch element 14A and the switch element 14B are simultaneously switched ON due to some kind of abnormal input, a high level signal is input to the another inputs of the AND element 22A and the AND element 22B of the operation limiting circuit 20 via the input terminal 26A and the input terminal 26B. One of the three inputs of the OR element 24A is input with a high level signal, and the other two inputs are input with low level signals. The output of the OR element 24A is thus a low level signal and so the output of the AND element 22A is a low level signal, thus the drive transistor 18A is switched OFF. Further, one of the three inputs of the OR element 24B is input with a high level signal, and the other two inputs are input with low level signals. The output of the OR element 24B is thus a low level signal and so the output of the AND element 22B is a low level signal, thus the drive transistor 18B is switched OFF similarly to the drive transistor 18A. Namely, in cases in which there is no need to simultaneously drive plural of the load elements 16A to 16D, the operation limiting circuit 20 is provided in advance with functionality so as to not allow plural of the drive transistors 18A to 18D to be switched ON simultaneously.

Thus, as plural of the drive transistors 18A to 18D are not switched ON simultaneously, no overcurrent arises flowing into the drive circuit 12 in the drive system 10. Further, in the operation limiting circuit 20, since the circuit configuration that implements ON-switching with a single control signal and OFF-switching with plural control signals is constructed from plural elements such as IGFETs that have, for example, smaller gate width dimensions than the gate width dimensions of the drive transistors 18A to 18D, the operation limiting circuit 20 is able to be simply implemented in a small area. The drive circuit 12 according to the present exemplary embodiment is thus able to protect against overcurrent and able to drive the plural load elements 16A to 16D with reduced circuit scale.

Moreover, in the drive circuit 12 according to the present exemplary embodiment, the AND elements 22A to 22D of the operation limiting circuit 20 are constructed using plural elements that have, for example, smaller gate width dimensions than the gate width dimensions of the drive transistors 18A to 18D as above. The AND elements 22A to 22D can therefore be formed in a small area, and moreover, be simply configured using standard logic elements.

Further, in the drive circuit 12 according to the present exemplary embodiment, similarly to the AND elements 22A to 22D, the OR elements 24A to 24D of the operation limiting circuit 20 can therefore be formed in a small area, and moreover, be simply configured using standard logic elements.

Further, in the drive circuit 12 according to the present exemplary embodiment, since overcurrent does not arise, the width, for example, of the wiring lines 40 that connect each of the drive transistors 18A to 18D to the respective output terminals 28A to 28D can be reduced. This too enables the circuit scale of the drive circuit 12 to be reduced.

### Second Exemplary Embodiment

Explanation follows regarding a drive circuit 12 and a drive system 10 according to a second exemplary embodiment of the present invention, with reference to Fig. 2. Note that in the present exemplary embodiment, configuration elements with the same or equivalent functions to configuration elements of the drive circuit 12 or drive system 10 according to the first exemplary embodiment are appended with the same reference sign, and duplicate explanation is omitted.

### Configuration of Drive Circuit and Drive System

As illustrated in Fig. 2, the drive circuit 12 according to the present exemplary embodiment is configured to drive a load 16 of the drive system 10 that includes two load elements: load element 16A and load element 16B. The drive circuit 12 therefore includes two drive transistors: a drive transistor 18A serving as a first drive transistor and a drive transistor 18B serving as a second drive transistor. The drive circuit 12 also includes an operation limiting circuit 20 that controls operation of the drive transistor 18A and the drive transistor 18B.

In place of the OR element 24A and the OR element 24B of the operation limiting circuit 20 of the first exemplary embodiment, this operation limiting circuit 20 is provided with a NOT element 42A and a NOT element 42B. The input of the NOT element 42A is connected to the input terminal 26B, and the output of the NOT element 42A is connected to one input of the AND element 22A. The input of the NOT element 42B is connected to the input terminal 26A, and the output of the NOT element 42B is connected to one input of the AND element 22B. The operation limiting circuit 20 operates the same as the operation limiting circuit 20 of the first exemplary embodiment.

The drive circuit 12 and the drive system 10 according to the present exemplary embodiment are capable of obtaining the same advantageous effects as the advantageous effects obtainable by the drive circuit 12 and the drive system 10 according to the first exemplary embodiment.

### Supplementary Explanation of the Exemplary Embodiments

The present invention is not limited to the above exemplary embodiments, and for example the following modifications may be implemented within a range not departing from the spirit of the present invention. For example, in the present invention, a motor may be employed as the load. Further, in the present invention, bipolar transistors may be employed as the drive transistors of the drive circuit. Further, in the present invention, three, or five or more load elements may be provided as the load for the drive system. In such cases, the number of drive transistors in the drive circuit is to be configured to match the number of load elements.

## Claims

1. A drive circuit comprising:
a first drive transistor and a second drive transistor each having one main electrode region connected to a power supply, and each having another main electrode region respectively connected to a first load or a second load; and
an operation limiting circuit that is connected to a first control electrode of the first drive transistor and connected to a second control electrode of the second drive transistor, the operation limiting circuit being configured to switch ON one of the first drive transistor or the second drive transistor when input with a single control signal for switching ON the one of the first drive transistor or the second drive transistor, and the operation limiting circuit being configured to switch OFF both the first drive transistor and the second drive transistor when input with a plurality of control signals for switching ON both the first drive transistor and the second drive transistor.

2. The drive circuit of claim 1, wherein:
the operation limiting circuit includes:
a first AND element that outputs to the first control electrode of the first drive transistor a control signal indicating a logical conjunction of a control signal for input to the first drive transistor and a control signal for input to the second drive transistor, and
a second AND element that outputs to the second control electrode of the second drive transistor a control signal indicating a logical conjunction of a control signal for input to the second drive transistor and a control signal for input to the first drive transistor.

3. The drive circuit of claim 2, wherein:
the operation limiting circuit includes:
a first OR element, or a first NOT element that outputs to the first AND element a control signal indicating a logical disjunction of control signals for input to the second drive transistor, and
a second OR element, or a second NOT element that outputs to the second AND element a control signal indicating a logical disjunction of control signals for input to the first drive transistor.
